(19) Europäisches Patentamt
European Patent Office
Office européen des brevets

(11) Veröffentlichungsnummer: **0 057 162**
**B1**

(12) **EUROPÄISCHE PATENTSCHRIFT**

(45) Veröffentlichungstag der Patentschrift: **27.06.84**

(21) Anmeldenummer: **82810026.3**

(22) Anmeldetag: **22.01.82**

(51) Int. Cl.³: **G 03 C 1/68**, G 03 C 1/727, G 03 F 7/10, G 03 F 7/26 // H01L21/312, H01L21/47

(54) **Verfahren zur Erzeugung von Abbildungen.**

(30) Priorität: **28.01.81 GB 8102847**

(43) Veröffentlichungstag der Anmeldung: **04.08.82 Patentblatt 82/31**

(45) Bekanntmachung des Hinweises auf die Patenterteilung: **27.06.84 Patentblatt 84/26**

(84) Benannte Vertragsstaaten: **BE CH DE FR GB IT LI NL SE**

(56) Entgegenhaltungen: **US - A - 4 009 040**

(73) Patentinhaber: **CIBA-GEIGY AG, Postfach, CH-4002 Basel (CH)**

(72) Erfinder: **Green, George Edward, Dr., 14 Vine Close Stapleford, Cambridge CB2 5BZ (GB)**
Erfinder: **Waterhouse, John Sidney, Dr., 9, Daws Close Cherry Hinton, Cambridge CB1 4LE (GB)**

**EP 0 057 162 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Vorliegende Erfindung betrifft ein Verfahren zur Erzeugung einer Abbildung unter Verwendung eines Positivphotoresists.

Bei der Erzeugung einer Abbildung unter Verwendung eines Positivphotoresists werden mit aktinischer Strahlung belichtete Teile des Resists löslicher oder leichter entfernbar als die unbelichteten Teile gemacht. Folglich lassen sich die belichteten Teile mit einem Entwickler entfernen, wobei die unbelichteten Teile als positive Abbildung bestehen bleiben. Solche eine Abbildung erzeugende Verfahren werden beispielsweise bei der Herstellung von Druckplatten und gedruckten Schaltungen verwendet.

Handelsübliche Positivphotoresists auf Grundlage von Chinondiazide enthaltenden Materialien sind nicht hitzebeständig. Ferner sind sie bei der Herstellung von gedruckten Schaltungen nicht gleichzeitig zur Verwendung als Resist und als Dielektrikum geeignet. Beispielsweise ist es bei der Herstellung von Mehrschichtschaltungen unter Verwendung von Positivresists erwünscht, daß das unbelichtete Resist ein gutes Dielektrikum darstellt, so daß das Resist vor dem Aufbau der Schichten nicht entfernt zu werden braucht. Die handelsüblichen Positivresists sind als Dielektrika zur Verwendung in solchen Schaltungen ungeeignet.

Positivphotoresists, die bei Belichtung mit aktinischer Strahlung depolymerisierende oder photolysierende Polymere enthalten, sind bekannt. Beispielsweise sind in der US-Patentschrift 4 009 040 Positivphotoresists beschrieben, die Kondensationspolymere mit Hexaarylbiimidazolgruppen sind. Ein Artikel von S. A. MacDonald, T. D. Schierling und C. G. Willson, Organic Coatings and Plastics Chemistry Preprints (Amer. Chem. Soc.), 1980, 43, 264—7, beschreibt N-Allyl-o-nitroarylamidgruppen enthaltende, durch Licht abbaubare Kondensationspolymere.

Es wurde nun überraschend gefunden, daß Harze oder Polymere, die gewisse substituierte Benzoingruppen enthalten, obwohl sie, wenn für sich bestrahlt, keine erhöhte Löslichkeit zeigen, in einem Entwickler löslicher werden, wenn sie im Gemisch mit einem Monomer bestrahlt werden, das unter der Einwirkung eines Radikalkatalysators zu höhermolekularem Material polymerisierbar ist, das in dem Entwickler löslicher ist als das Gemisch vor der Bestrahlung. Solche Gemische sind deshalb als Positivphotoresists verwendbar. Diese Resists sind hitzebeständig. Wenn ferner das unbelichtete Harz oder Polymer heißhärtbar ist, so kann man das Resist bei der Herstellung von mehrschichtigen gedruckten Schaltungen verwenden, ohne daß der unbelichtete Teil vor dem Verkleben der Schichten entfernt zu werden braucht.

Gegenstand vorliegender Erfindung ist ein Verfahren zur Erzeugung von Abbildungen, wobei man eine positive Photoresistzusammensetzung mit aktinischer Strahlung bildweise belichtet und danach die Zusammensetzung mit einem Entwickler behandelt, um den belichteten Teil zu entfernen, welches dadurch gekennzeichnet ist, daß die Photoresistzusammensetzung besteht aus: (a) einem filmbildenden organischen Material mit mindestens einer substituierten Benzoingruppe der Formel

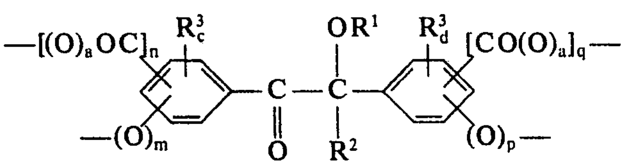

(I)

worin $R^1$ für ein Wasserstoffatom, eine Alkyl-, Cycloalkyl-, Cycloalkylalkyl- oder Aralkylgruppe oder eine Gruppe $-(CH_2)_bX$, $R^2$ für ein Wasserstoffatom oder eine Alkyl-, Cycloalkyl-, Cycloalkylalkyl-, Aryl- oder Aralkylgruppe, $R^3$ für ein Halogenatom oder eine Alkyl-, Alkoxy-, Cycloalkyl-, Cycloalkylalkyl- oder Phenylgruppe, X für ein Halogenatom, eine Alkoxygruppe, eine Phenoxygruppe, eine Gruppe $-COOR^4$ oder eine Gruppe $-OOCR^4$ und $R^4$ für eine Alkylgruppe stehen sowie a Null oder 1, b eine ganze Zahl von 1 bis 4, m Null oder 1, n Null oder 1, wobei die Summe von $m+n = 1$ ist, p Null oder 1, q Null oder 1, wobei die Summe von $p+q = 1$ ist, c Null oder eine ganze Zahl von 1 bis 3 und d Null oder eine ganze Zahl von 1 bis 3 sind, und (b) einer Verbindung, die unter der Einwirkung eines Radikalkatalysators zu höhermolekularem Material polymerisierbar ist, das in einem Entwickler löslicher ist als die Zusammensetzung vor der Belichtung, so daß die Löslichkeit der Zusammensetzung im Entwickler in dem belichteten Teil zunimmt.

In der Formel I bedeutet $R^1$ im allgemeinen ein Wasserstoffatom, eine Alkylgruppe mit 1 bis 12, vorzugsweise 1 bis 6 Kohlenstoffatomen, eine Cycloalkylgruppe mit 3 bis 8 Kohlenstoffatomen, eine Cycloalkylalkylgruppe mit 4 bis 10 Kohlenstoffatomen, eine Aralkylgruppe mit 7 bis 16, vorzugsweise 7 bis 10 Kohlenstoffatomen oder eine Gruppe $-(CH_2)_bX$, wobei X ein Halogenatom, vorzugsweise ein Chlor- oder Bromatom, darstellt, eine Alkoxygruppe mit 1 bis 4 Kohlenstoffatomen, vorzugsweise eine Methoxygruppe, eine Phenoxygruppe, eine Gruppe $-COOR^4$ oder eine Gruppe $-OOCR^4$, wobei $R^4$ eine Alkylgruppe mit 1 bis 4 Kohlenstoffatomen darstellt und b eine ganze Zahl von 1 bis 3 ist. In besonders bevorzugten Ausführungsformen bedeutet $R^1$ ein Wasserstoffatom oder eine Alkylgruppe mit 1 bis 4 Kohlenstoffatomen.

$R^2$ bedeutet im allgemeinen ein Wasserstoffatom, eine Alkylgruppe mit 1 bis 12, vorzugsweise 1 bis 6

Kohlenstoffatomen, eine Cycloalkylgruppe mit 3 bis 8 Kohlenstoffatomen, eine Cycloalkylalkylgruppe mit 4 bis 10 Kohlenstoffatomen, eine Aralkylgruppe mit 7 bis 16 Kohlenstoffatomen oder eine Arylgruppe mit 6 bis 12 Kohlenstoffatomen. In besonders bevorzugten Ausführungsformen bedeutet $R^2$ ein Wasserstoffatom oder eine Alkylgruppe mit 1 bis 4 Kohlenstoffatomen.

$R^3$, wenn vorhanden, bedeutet im allgemeinen ein Halogenatom, vorzugsweise ein Chlor- oder Bromatom, eine Alkylgruppe mit 1 bis 4 Kohlenstoffatomen, eine Cycloalkylgruppe mit 3 bis 8 Kohlenstoffatomen, eine Phenylgruppe oder eine Alkoxygruppe mit 1 bis 4 Kohlenstoffatomen. Vorzugsweise befindet sich jeweils nicht mehr als ein Substituent $R^3$ an den angegebenen Ringen. Vorzugsweise sind keine Substituenten $R^3$ an den Ringen vorhanden, d. h. c und d sind beide Null.

Die angegebenen, an die aromatischen Ringe in der Formel I gebundenen Sauerstoffatome und Carbonyl(oxy)gruppen können in ortho- oder meta-Stellung zu den mit der Acyloinbrücke verknüpften Ringkohlenstoffatomen gebunden sein, doch sind sie vorzugsweise in para-Stellung zu diesen Atomen gebunden.

Besonders bevorzugte Einheiten der Formel I sind solche, worin $R^1$ für ein Wasserstoffatom oder eine Alkylgruppe mit 1 bis 4 Kohlenstoffatomen und $R^2$ für ein Wasserstoffatom stehen sowie c und d beide Null sind.

Das filmbildende Material (a) soll vorzugsweise mindestens drei Gruppen der Formel I enthalten. Im Rahmen dieses Erfordernisses kann die Anzahl solcher Gruppen je nach der Art und dem Molekulargewicht des Materials (a) in weiten Grenzen schwanken. Beispielsweise kann ein als (a) verwendbares Polymer bis zu 200 solche Gruppen enthalten.

Eine oder mehrere Gruppen der Formel I enthaltende, filmbildende Harze oder Polymere lassen sich dadurch herstellen, daß man eine Verbindung der Formel

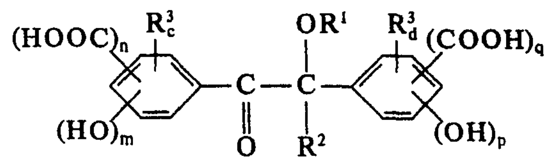

(II)

worin die Symbole die oben angegebenen Bedeutungen haben, mit einer Verbindung umsetzt, die 2 mit den angegebenen Carboxyl- oder phenolischen Hydroxylgruppen reaktionsfähige Gruppen aufweist. Gruppen der Formel I (worin n und q beide Null sind) enthaltende Polyurethane lassen sich durch Umsetzung einer Verbindung der Formel II, worin m und p beide 1 sowie n und q beide Null sind, mit einem Diisocyanat wie Toluylendiisocyanat erhalten. Gruppen der Formel I (worin n und q beide 1 sowie a Null sind) enthaltende Polyamide kann man durch Umsetzung einer Verbindung der Formel II, worin n und q beide 1 sowie m und p beide Null sind, mit einem Diamin wie Hexamethylendiamin erhalten. Polycarbonate sind durch Umsetzung einer Verbindung der Formel II, falls diese ein Bisphenol ist, mit Diphenylcarbonat erhältlich. Polysulfone können aus einer Verbindung der Formel II, falls diese ein Bisphenol ist, durch Umsetzung ihres Natriumsalzes mit 4,4'-Dichlordiphenylsulfon erhalten werden. Phenoxyharze sind durch Umsetzung eines Bisphenols der Formel II mit einem stöchiometrischen Unterschuß eines Epoxidharzes herstellbar.

Eine oder mehrere Einheiten der Formel I enthaltende, filmbildende Harze oder Polymere kann man auch dadurch herstellen, daß man eine Verbindung der Formel II mit einem Monoepoxid, zum Beispiel einem Alkylenoxyd wie Äthylenoxyd oder Propylenoxyd, umsetzt, um die angegebene(n) phenolische(n) Hydroxylgruppe(n) zu veräthern bzw. die angegebene(n) Carboxylgruppe(n) zu verestern, wodurch 2 alkoholische Hydroxylgruppen eingeführt werden, und das Produkt mit einer Verbindung, die 2 mit den alkoholischen Hydroxylgruppen reaktionsfähige Gruppen aufweist, beispielsweise einem Diisocyanat oder einer Dicarbonsäure umsetzt.

Als beim erfindungsgemäßen Verfahren verwendbare, filmbildende Materialien mit mindestens einer Gruppe der Formel I werden Epoxidharze, Polyester und Polyurethane bevorzugt.

Geeignete Epoxidharze mit einer oder mehreren Gruppen der Formel I sind unter anderem Diglycidyläther, die man durch Umsetzung einer Verbindung der Formel II, worin m und p beide 1 sind, mit Epichlorhydrin oder Glycerindichlorhydrin unter alkalischen Bedingungen, oder auch in Gegenwart eines sauren Katalysators mit nachfolgender Alkalibehandlung, erhält. Als Epoxidharze eignen sich ferner Diglycidylester, die man durch Umsetzung einer Verbindung der Formel II, worin n und q beide 1 sind, mit Epichlorhydrin oder Glycerindichlorhydrin in Gegenwart eines Alkalis erhält. Weitere beim erfindungsgemäßen Verfahren verwendbaren Epoxidharze sind gemischte Glycidyläther/Glycidylesterharze, die man durch Umsetzung einer Verbindung der Formel II, worin entweder m und q beide 1 oder n und p beide 1 sind, mit Epichlorhydrin oder Glycerindichlorhydrin in Gegenwart eines Alkalis erhält. Ferner kommen Diglycidyläther der durch Umsetzung einer Verbindung der Formel II mit einem Monoepoxid, wie schon beschrieben, erhaltenen Alkohole in Betracht.

Ferner erhält man geeignete Epoxidharze mit einer oder mehreren Einheiten der Formel I durch eine Anlagerungsreaktion eines wie oben beschrieben hergestellten Diglycidyläthers, Diglycidylesters oder gemischten Glycidyläther/Glycidylesters mit einem stöchiometrischen Unterschuß einer difunktionellen Verbindung mit zwei Gruppen, die mit den Epoxidgruppen der oben erwähnten Glycidylderivate unter Bildung von höhermolekularen Epoxidharzen reagieren. Diese Anlagerungsreaktion, sonst allgemein als Vorverlängerungsreaktion bekannt, kann in Gegenwart einer Base oder eines quartären Ammoniumsalzes als Katalysator durchgeführt werden. Typische, bei Vorverlängerungsreaktionen verwendete difunktionelle Verbindungen sind unter anderem Bisphenole wie Bisphenol A (d. h. 2,2-Bis-(4-hydroxyphenyl)-propan), einkernige zweiwertige Phenole wie Resorcin, Dicarbonsäuren wie Hexahydrophthalsäure und Hydantoine wie 5,5-Dimethylhydantoin.

Beim erfindungsgemäßen Verfahren als Komponente (a) bevorzugt in Frage kommende Epoxidharze sind solche der Formel

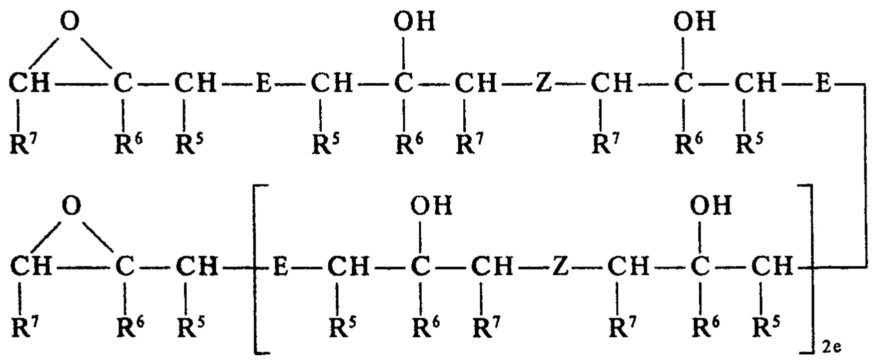

(III)

worin E den Rest eines Diepoxids nach Wegnahme zweier Gruppen der Formel

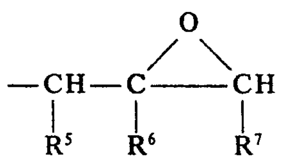

(IV)

darstellt, wobei dieser Rest über Sauerstoff-, Stickstoff- oder Schwefelatome an die angegebenen Kohlenstoffatome gebunden ist, Z eine Gruppe der Formel I mit a = 1 bedeutet, $R^5$ und $R^7$ entweder beide für ein Wasserstoffatom stehen, wobei $R^6$ dann ein Wasserstoffatom oder eine Methylgruppe bedeutet, oder zusammen für $-CH_2CH_2-$ stehen, wobei $R^6$ dann ein Wasserstoffatom bedeutet, und e Null oder eine ganze Zahl von 1 bis 50 ist.

Harze der Formel III lassen sich durch Vorverlängerung einer Verbindung der Formel II mit einem stöchiometrischen Überschuß eines Polyepoxids mit mehr als 1, aber nicht mehr als 2 direkt an Sauerstoff-, Stickstoff- oder Schwefelatome gebundenen Gruppen der Formel IV pro Durchschnittsmolekül erhalten. Im allgemeinen setzt man 0,75 bis 1 phenolisches Hydroxyl- und/oder Carboxyläquivalent der Verbindung der Formel II je 1,2-Epoxidgruppe im Polyepoxid ein.

Als Beispiele für solche Polyepoxide seien Polyglycidyl- und Poly-($\beta$-methylglycidyl)-ester genannt, die man durch Umsetzung einer zwei Carbonsäuregruppen pro Molekül enthaltenden Verbindung mit Epichlorhydrin, Glycerindichlorhydrin oder $\beta$-Methylepichlorhydrin in Gegenwart von Alkali erhalten kann. Solche Polyglycidylester können sich von aliphatischen Polycarbonsäuren, z. B. Bernsteinsäure, Glutarsäure, Adipinsäure, Pimelinsäure, Korksäure, Azelainsäure, Sebacinsäure oder dimerisierter Linolsäure, von cycloaliphatischen Polycarbonsäuren wie Tetrahydrophthalsäure, 4-Methyltetrahydrophthalsäure, Hexahydrophthalsäure und 4-Methylhexahydrophthalsäure sowie von aromatischen Polycarbonsäuren wie Phthalsäure, Isophthalsäure und Terephthalsäure ableiten.

Weitere Beispiele sind Polyglycidyl- und Poly-($\beta$-methylglycidyl)-äther, die durch Umsetzung einer zwei freie alkoholische oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung, erhältlich sind. Diese Äther lassen sich aus acyclischen Alkoholen wie Äthylenglykol, Diäthylenglykol und höheren Poly-(oxyäthylen)-glykolen, Propan-1,2-diol und Poly-(oxypropylene)-glykolen, Propan-1,3-diol, Poly-(oxytetramethylen)-glykolen und Pentan-1,5-diol, aus cycloaliphatischen Alkoholen wie Resorcit und Chinit, Bis-(4-hydroxycyclohexyl)-methan, 2,2-Bis-(4-hydroxycyclohexyl)-propan und 1,1-Bis-(hydroxymethyl)-cyclohexen-3 sowie aus Alkoholen mit aromatischen Kernen wie N,N-Bis-(2-hydroxyäthyl)-anilin und p,p'-Bis-(2-hydroxyäthylamino)-diphenylmethan herstellen. Ferner sind sie aus einkernigen Phenolen wie Resorcin und Hydrochinon und aus mehrkernigen Phenolen wie Bis-(4-hydroxyphenyl)-methan (sonst als Bisphenol F bekannt), 4,4'-Dihydroxydiphenyl, Bis-(4-hydroxyphenyl)-sulfon, 2,2-Bis-(4-hydroxyphenyl)-propan und 2,2-Bis-(3,5-dibrom-4-hydroxyphenyl)-propan herstellbar.

Ebenfalls in Betracht kommen Poly-(N-glycidyl)-verbindungen, z. B. N-Glycidylderivate von Aminen wie Anilin, n-Butylamin, Bis-(4-aminophenyl)-methan und Bis-(4-methylaminophenyl)-methan sowie N,N'-Diglycidylderivate von cyclischen Alkylenharnstoffen wie Äthylenharnstoff und 1,3-Propylenharnstoff sowie Hydantoine wie 5,5'-Dimethylhydantoin.

Poly-(S-glycidyl)-verbindungen sind ebenfalls verwendbar, z. B. Di-(S-glycidyl)-derivate von Dithiolen wie Äthan-1,2-dithiol und Bis-(4-mercaptomethylphenyl)-äther, doch sind diese nicht bevorzugt.

Beispiele für Polyepoxide mit Gruppen der Formel IV, worin $R^5$ und $R^7$ zusammen für eine $-CH_2CH_2$-Gruppe stehen, sind Bis-(2,3-epoxycyclopentyl)-äther, 2,3-Epoxycyclopentyl-glycidyläther und 1,2-Bis-(2,3-epoxycyclopentyloxy)-äthan.

In Betracht kommen auch Polyepoxide, in welchen die 1,2-Epoxidgruppen an Heteroatome verschiedener Art gebunden sind, z. B. der Glycidyläther/Glycidylester der Salicylsäure.

Ebenfalls einsetzbar sind Polyepoxide, in denen einige oder sämtliche Epoxidgruppen mittelständig sind, wie Vinylcyclohexendioxyd, Limonendioxyd, Dicyclopentadiendioxyd, 4-Oxatetracyclo[6,2,1,$0^{2,7}$,$0^{3,5}$]undecyl-(9)-glycidyläther, 1,2-Bis-(4-oxatetracyclo[6,2,1,$0^{2,7}$,$0^{3,5}$]undecyl-(9)-oxy)-äthan, der 3,4-Epoxycyclohexylmethylester der 3',4'-Epoxycyclohexancarbonsäure sowie dessen 6,6'-Dimethylderivat, der Bis-(3,4-epoxycyclohexancarbonsäureester) des Äthylenglykols und 3-(3,4-epoxycyclohexyl)-8,9-epoxy-2,4-dioxaspiro[5,5]undecan.

Gewünschtenfalls kann man ein Polyepoxidgemisch verwenden.

Besonders bevorzugte, bei dem erfindungsgemäßen Verfahren verwendete Epoxidharze sind solche der Formel III, worin E für den Rest eines Diglycidyläthers oder eines zweiwertigen Phenols, wie 2,2-Bis-(4-hydroxyphenyl)-propan und Bis-(4-hydroxyphenyl)-methan, oder eines zweiwertigen aliphatischen Alkohols wie Butan-1,4-diol oder den Rest eines Di-(N-glycidyl)-derivats eines Hydantoins steht.

Die Umsetzung der Verbindung der Formel II mit dem Polyepoxid erfolgt vorzugsweise in Lösung in einem organischen Lösungsmittel und in Gegenwart eines Katalysators, wofür ein tertiäres Amin wie N-Benzyldimethylamin oder ein quartäres Ammoniumsalz wie Tetramethylammoniumchlorid in Frage kommt.

Polyester mit einer oder mehreren Gruppen der Formel I kann man dadurch erhalten, daß man eine Verbindung der Formel II, falls diese ein Bisphenol ist (d. h. worin m und p beide 1 sind), mit einer Dicarbonsäure oder einem esterbildenden Derivat davon, wie einem Halogenid, Anhydrid, Amid oder Niederalkylester davon (wobei »Niederalkyl« als Alkyl mit 1 bis 4 Kohlenstoffatomen zu verstehen ist), umsetzt. Als Beispiele für solche Dicarbonsäurereagenzien seien aliphatische Disäuren wie Bernsteinsäure, Glutarsäure, Adipinsäure oder Sebacinsäure, cycloaliphatische Disäuren wie Hexahydrophthalsäure und Hexahydroterephthalsäure, aromatische Disäuren wie Phthalsäure und Terephthalsäure sowie esterbildende Derivate dieser Disäuren genannt.

Weitere geeignete Polyester kann man durch Umsetzung einer Verbindung der Formel II, falls dies eine Disäure ist (d. h. worin n und q beide 1 sind), oder ein esterbildendes Derivat davon, wie ein Halogenid, Anhydrid, Amid oder Niederalkylester davon, mit einem zweiwertigen Alkohol oder zweiwertigen Phenol erhalten. Als Beispiele für zweiwertige Alkohole seinen Äthylenglykol, Diäthylenglykol, Triäthylenglykol, Propylenglykol, Dipropylenglykol, Propan-1,3-diol, Butan-1,4-diol, Hexan-1,6-diol, Chinit, Bis-(4-hydroxycyclohexyl)-methan und 2,2-Bis-(4-hydroxycyclohexyl)-propan genannt. Zu erwähnende Beispiele für zweiwertige Phenole sind Resorcin, Bis-(4-hydroxyphenyl)-methan, 4,4'-Dihydroxybiphenyl, Bis-(4-hydroxyphenyl)-sulfon und 2,2-Bis-(4-hydroxyphenyl)-propan.

Die Polyesterbildungsreaktion zwischen dem zweiwertigen Phenol oder zweiwertigen Alkohol und der Disäure oder deren esterbildendem Derivat erfolgt vorzugsweise in Lösung in einem organischen Lösungsmittel unter Verwendung eines herkömmlichen Katalysators wie eines tertiären Amins bzw., falls das esterbildende Derivat ein Niederalkylester ist, in Gegenwart eines Umesterungskatalysators. Die Reaktionspartner werden in solchen Mengen eingesetzt, daß man einen Polyester mit 1 bis 200, vorzugsweise 3 bis 100 Benzoineinheiten erhält. Üblicherweise setzt man 0,75 bis 1,25 Mol zweiwertiges Phenol oder zweiwertigen Alkohol pro Mol Disäure ein.

Bevorzugt sind solche Polyester, die man durch Umsetzung einer Verbindung der Formel II, worin m und p beide 1 sind, mit einer aliphatischen Dicarbonsäure oder einem esterbildenden Derivat davon, insbesondere einem Acylchlorid, oder durch Umsetzung eines Diniederalkylesters einer Verbindung der Formel II, worin n und q beide 1 sind, mit einem zweiwertigen Alkohol erhält.

Polyurethane mit einer oder mehreren Gruppen der Formel I kann man dadurch erhalten, daß man ein Bisphenol der Formel II mit einem aliphatischen, cycloaliphatischen, aromatischen, araliphatischen oder heterocyclischen Diisocyanat oder einem Präpolymer davon umsetzt. Beispiele für solche Diisocyanate sind unter anderem 1,6-Diisocyanatohexan und dessen 2,2,4- und 2,4,4-Trimethylhomologe, 2,4- und 2,6-Diisocyanatotoluol, 1,5-Diisocyanatonaphthalin, Bis-(4-isocyanatophenyl)-methan, 2,4- und 2,6-Diisocyanatomethylcyclohexan und 3-Isocyanatomethyl-3,5,5-trimethylcyclohexylisocyanat.

Bei der Herstellung von Polymeren wie Polyestern und Polyurethanen aus einer Verbindung der Formel II oder einem Monoepoxidaddukt davon als Hydroxylverbindung ist es vorzuziehen, daß $R^1$ von einem Wasserstoffatom verschieden ist, d. h. die Verbindung der Formel II soll vorzugsweise nur zwei Hydroxylgruppen enthalten. Dadurch wird es unnötig, die Polymerbildungsreaktion unter sorgfältig kontrollierten Bedingungen durchzuführen, um weitgehende Vernetzung zu vermeiden.

Gruppen der Formel I enthaltende Polyester sind als Photoinitiatoren in der US-Patentschrift 3 728 377 beschrieben. Es ist anzunehmen, daß Epoxidharze (und die weiteren bezeichneten Harze oder Polymere), die eine oder mehrere solche Gruppen enthalten, und folglich die Zusammensetzungen, welche diese zusammen mit einer Verbindung (b) enthalten, neu sind.

Verbindungen der Formel II, worin m und p beide 1 sind sowie $R^1$ und $R^2$ beide für ein Wasserstoffatom stehen, lassen sich auf folgende Weise erhalten. Ein hydroxylsubstituierter Benzaldehyd, gegebenenfalls mit einem oder mehreren weiteren Substituenten $R^3$, oder ein Gemisch solcher hydroxylsubstituierter Benzaldehyde wird nach der von J. P. Yardley und H. Fletcher (Synthesis, 1976, 244) beschriebenen Methode mit Dimethoxymethan umgesetzt, um die phenolische(n) Hydroxylgruppe(n) in Methoxymethoxygruppen zu überführen. Das Produkt unterwirft man einer Benzoinkondensation zu einem Dimethoxymethoxybenzoin. Die Methoxymethylschutzgruppen werden dann durch Umsetzung mit einer Mineralsäure unter Bildung eines Dihydroxybenzoins entfernt. Solche Verbindungen lassen sich auch aus den entsprechenden Dihydroxybenzilen erhalten. Ein Dihydroxybenzil wird nach der von N. J. Leonard u. a. (J. Amer. Chem. Soc., 1949, 71, 2997) beschriebenen Methode hergestellt, indem man einen Methoxybenzaldehyd, gegebenenfalls mit einem oder mehreren Substituenten $R^3$, oder ein Gemisch solcher Methoxybenzaldehyde einer Benzoinkondensation unterwirft, das entstandene Dimethoxybenzoin zum entsprechenden Benzil oxydiert und das Benzil zur Spaltung der Methoxygruppen mit Bromwasserstoffsäure behandelt. Das so erhaltene Dihydroxybenzil wird mit Zinn und Salzsäure zum Dihydroxybenzoin reduziert.

Verbindungen der Formel II, worin m und p beide 1 sind, $R^1$ für eine der bezeichneten organischen Gruppen und $R^2$ für ein Wasserstoffatom stehen, sind durch Umsetzung eines wie oben beschrieben hergestellten Dihydroxybenzoins mit einem Alkohol $R^1OH$ in Gegenwart eines Säurekatalysators wie Toluol-4-sulfonsäure herstellbar.

Verbindungen der Formel II, worin n und q beide 1 sind und $R^1$ und $R^2$ beide für ein Wasserstoffatom stehen, kann man dadurch herstellen, daß man einen Carbalkoxybenzaldehyd, gegebenenfalls mit einem oder mehreren Substituenten $R^3$, oder ein Gemisch solcher Carbalkoxybenzaldehyde wie in US-Patentschrift 3 728 377 beschrieben einer Benzoinkondensation zu einem Dicarbalkoxybenzoin unterwirft und die Estergruppen mittels Säure oder Alkali zum Dicarboxybenzoin hydrolysiert.

Verbindungen der Formel II, worin n und q beide 1 sind, $R^1$ für eine der bezeichneten organischen Gruppen steht und $R^2$ ein Wasserstoffatom bedeutet, sind durch Umsetzung eines wie oben beschriebenen Dicarbalkoxybenzoins mit einem Alkohol $R^1OH$ in Gegenwart eines Säurekatalysators und anschließende saure oder alkalische Hydrolyse der Estergruppen erhältlich.

Verbindungen der Formel II, worin eins von m und p 1 ist, eins von n und q 1 ist sowie $R^1$ und $R^2$ beide für ein Wasserstoffatom stehen, kann man dadurch erhalten, daß man ein Gemisch aus einem wie oben beschrieben hergestellten methoxymethoxysubstituierten Benzaldehyd und einem Carbalkoxybenzaldehyd zu einem Methoxymethoxy-carbalkoxybenzoin unterwirft und dieses anschließend zur Hydrolyse der Äthergruppe und Estergruppe und Bildung eines Hydroxycarboxybenzoins mit einer Mineralsäure umsetzt.

Verbindungen der Formel II, worin eins von m und p 1 ist, eins von n und q 1 ist, $R^1$ für eine der bezeichneten organischen Gruppen steht und $R^2$ ein Wasserstoffatom bedeutet, sind durch Umsetzung eines wie oben beschrieben hergestellten Hydroxycarboxybenzoins mit einem Alkohol $R^1OH$ in Gegenwart eines Säurekatalysators, wobei Verätherung der Hydroxylgruppe am Kohlenstoffatom in alpha-Stellung zur Carbonylgruppe und gleichzeitig Veresterung der an den Ring gebundenen Carboxylgruppe eintritt, und nachfolgende Hydrolyse der Estergruppe, um diese wieder in eine Carboxylgruppe zu überführen, erhältlich.

Verbindungen der Formel II, worin $R^1$ für ein Wasserstoffatom und $R^2$ für eine der bezeichneten organischen Gruppen steht, kann man so erhalten, daß man ein Dimethoxymethoxybenzoin, ein Dicarbalkoxybenzoin bzw. ein Methoxymethoxycarbalkoxybenzoin, wobei alle diese wie oben beschrieben hergestellt sind, mit Natriummethylat zum Natriumderivat umsetzt, dieses mit einem Halogenid $R^2Y$, worin Y für ein Halogenatom steht, beispielsweise Methyljodid, tert.-Butylbromid oder Benzylbromid, zum entsprechenden $\alpha$-substituierten Benzoin reagieren läßt und dann die Methoxymethoxygruppen und bzw. oder Estergruppen wie oben beschrieben hydrolysiert.

Verbindungen der Formel II, worin m und p beide 1 sind, $R^1$ ein Wasserstoffatom bedeutet und $R^2$ für eine der bezeichneten organischen Gruppen steht, lassen sich ferner dadurch erhalten, daß man ein durch Oxydation des entsprechenden Dimethoxymethoxybenzoins erhaltenes Dimethoxymethoxybenzil mit einem Grignard-Reagenz zum entsprechenden alphasubstituierten Dimethoxymethoxybenzoin umsetzt und anschließend wie oben beschrieben die Methoxymethlgruppen entfernt.

Verbindungen der Formel II, worin sowohl $R^1$ als auch $R^2$ für eine der bezeichneten organischen Gruppen stehen, kann man durch Umsetzung der entsprechenden Verbindungen, worin $R^1$ für ein Wasserstoffatom steht, mit einem Alkohol $R^1OH$ in Gegenwart eines Säurekatalysators und gegebenenfalls nachträgliche Hydrolyse der an den bzw. die Ring(e) gebundenen Estergruppe(n) erhalten.

Die polymerisierbare Verbindung (b) ist eine Verbindung, die sich unter der Einwirkung eines Radikalkatalysators in höhermolekulares Material umwandelt, das in einem Entwickler löslicher ist als die Resistzusammensetzung vor der Belichtung. Beispielsweise kann die Verbindung (b) eine funktionelle Gruppe enthalten, die das höhermolekulare Material in einem Lösungsmittel löslich macht, in welchem die Resistzusammnensetzung unlöslich ist. Es wird angenommen, obwohl die Anwendbarkeit der Erfindung nicht von der Richtigkeit dieser Annahme abhängig ist, daß das Material (a) bei Belichtung mit aktinischer Strahlung unter Bildung von Bruchstücken photolysiert, welche freie Radikale sind und eine Polymerisation der Verbindung (b) einleiten, und daß das dadurch entstandene

höhermolekulare Material an die durch die Photolyse erzeugten Bruchstücke des Materials (a) gebunden wird.

Vorzugsweise enthält die Verbindung (b) eine oder mehrere funktionelle Gruppen solcher Art, daß sie zu höhermolekularem, in wäßrigen Lösungsmitteln, insbesondere basischen oder sauren Lösungen, löslichem Material polymerisierbar ist, so daß der belichtete Teil des Resists in einem wäßrigen Entwickler, beispielsweise einem wäßrig-alkalischen Entwickler wie einer wäßrigen Lösung von Natriumhydroxyd, Natriumcarbonat oder Dinatriumhydrogenphosphat oder einem wäßrig-sauren Entwickler wie einer wäßrigen Mineralsäurelösung, löslich ist.

Löslichkeit in wäßrig-alkalischen Lösungen verleihende funktionelle Gruppen sind unter anderem Sulfonsäuregruppen und insbesondere Carboxylgruppen. Als Verbindung (b) kann daher eine Verbindung mit einer äthylenisch ungesättigten Gruppe und einer Sulfonsäuregruppe, z. B. Vinylsulfonsäure, vorliegen. Vorzugsweise ist (b) eine Verbindung mit einer äthylenisch ungesättigten Gruppe und einer oder mehreren Carboxylgruppen. Als Beispiele für solche Verbindungen seien Crotonsäure, 3-Butensäure, Itaconsäure, Maleinsäure und Fumarsäure genannt.

Als äthylenisch ungesättigte Carboxylverbindungen werden solche bevorzugt, die eine äthylenisch ungesättigte Estergruppe und eine oder mehrere Carboxylgruppen enthalten. Die Estergruppe kann beispielsweise eine Crotonoyloxygruppe, eine Itaconoyloxygruppe oder insbesondere eine Acryloyloxy- oder Methacryloyloxygruppe sein. Solche Verbindungen können der Formel

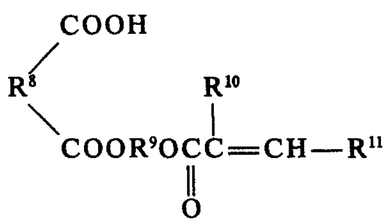

(V)

entsprechen, worin $R^8$ für eine über Kohlenstoffatome an die Kohlenstoffatome der angegebenen Carbonylgruppen gebundene, zweiwertige organische Gruppe, $R^9$ für eine gegebenenfalls durch ein oder mehrere Sauerstoffatome in der Kette unterbrochene Alkylengruppe, $R^{10}$ für ein Wasserstoffatom, ein Halogenatom oder eine Alkylgruppe mit 1 bis 4 Kohlenstoffatomen und $R^{11}$ für ein Wasserstoffatom oder eine Alkylgruppe mit 1 bis 3 Kohlenstoffatomen stehen.

Vorzugsweise bedeutet $R^8$ eine Alkylengruppe mit 1 bis 4 Kohlenstoffatomen, eine Cycloalkylengruppe mit 4 bis 8 Kohlenstoffatomen oder eine Arylengruppe mit 6 bis 12 Kohlenstoffatomen, wobei die Alkylen-, Cycloalkylen- oder Arylengruppe gegebenenfalls durch eine oder mehrere Carboxylgruppen substituiert ist.

$R^9$ stellt vorzugsweise eine Alkylengruppe mit 2 bis 6 Kohlenstoffatomen sowie $R^{10}$ und $R^{11}$ jeweils vorzugsweise ein Wasserstoffatom oder eine Methylgruppe dar.

Verbindungen der Formel V lassen sich durch Umsetzung eines Polycarbonsäureanhydrids der Formel

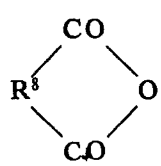

(VI)

mit einem Hydroxyalkylester der Formel

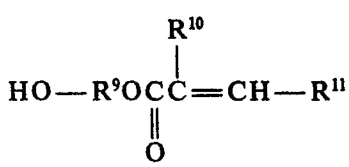

(VII)

worin $R^8$, $R^9$, $R^{10}$ und $R^{11}$ die oben angegebenen Bedeutungen haben, herstellen.

Die Umsetzung wird üblicherweise unter Einsatz von 0,8 bis 1,2 Mol Anhydrid pro Mol Hydroxyalkylester in einem organischen Lösungsmittel in Gegenwart eines tertiären Amins als Katalysator und eines Polymerisationsinhibitors durchgeführt. Besonders bevorzugte Polycarbonsäureanhydride sind Bernsteinsäureanhydrid, Phthalsäureanhydrid und Trimellithsäureanhydrid. Als Hydroxyalkylester wird 2-Hydroxyäthylacrylat besonders bevorzugt.

Zu funktionellen Gruppen, die Löslichkeit in wäßrig-sauren Lösungen verleihen, gehören Aminogruppen. Verbindung (b) kann somit eine Verbindung mit einer äthylenisch ungesättigten Gruppe und einer oder mehreren Aminogruppen, insbesondere sekundären oder tertiären Aminogruppen, sein. Als

Beispiele für solche Verbindungen sind Alkylaminoalkylacrylate oder -methacrylate wie 2-(tert.-Butylamino)-äthylmethacrylat, Dialkylaminodialkylacrylate und -methacrylate, wie 2-(Dimethylamino)-äthylmethacrylat und 2-(Diäthylamino)-äthylacrylat, sowie Vinylpyridine wie 2-Vinylpyridin, 4-Vinylpyridin und 2-Methyl-5-vinylpyridin zu nennen.

In der Photoresistzusammensetzung kann ein Gemisch aus zwei oder mehr polymerisierbaren Verbindungen (b) jeweils mit einer löslichmachenden funktionellen Gruppe vorliegen. Ebenfalls kann man ein Gemisch einer polymerisierbaren Verbindung (b) mit einer solchen funktionellen Gruppe und eines copolymerisierbaren Monomers ohne eine solche Gruppe einsetzen.

Die relativen Mengen (a) und (b) in der Photoresistzusammensetzung können je nach dem Molekulargewicht von (a) schwanken, d. h. je nach der Anzahl Gruppen der Formel I in (a). Im allgemeinen setzt man mindestens 1 Mol (b) pro Gruppe der Formel I in (a) ein. Es versteht sich, daß die Menge (b) nicht so groß sein darf, daß sie die Zusammensetzung vor der Belichtung im gewählten Entwickler löslich macht oder die Bildung eines geeigneten Films auf einem Träger verhindert.

Bei Verwendung eines Epoxidharzes als filmbildendes Material (a) kann die Resistzusammensetzung auch ein latentes, hitzeaktivierbares Vernetzungsmittel für das Harz enthalten, so daß man nach Belichtung mit aktinischer Strahlung und Entwickeln der Abbildung den unbelichteten Teil des Resists durch Erhitzen vernetzen kann. Als hitzeaktivierbare Mittel eignen sich unter anderem Polycarbonsäureanhydride, Komplexe von Aminen, insbesondere primären oder tertiären aliphatischen Aminen wie Äthylamin, Trimethylamin und n-Octyldimethylamin, mit Bortrifluorid oder Bortrichlorid, aromatische Polyamine, Imidazole, 2,6-Xylyl-biguanid und Dicyandiamid. Enthält die polymerisierbare Verbindung (b) zwei oder mehr funktionelle Gruppen, die bei erhöhten Temperaturen mit Epoxidgruppen reaktionsfähig sind, wie Carboxylgruppen, so kann der Zusatz eines weiteren hitzeaktivierbaren Vernetzungsmittels entfallen.

Bei der Durchführung des erfindungsgemäßen Verfahrens kann man eine Schicht Resistzusammensetzung auf einen Träger aufbringen, indem man diesen mit einer Lösung der Zusammensetzung in einem zweckmäßigen Lösungsmittel, z. B. Cyclohexanon, 2-Äthoxyäthanol, Äthylmethylketon, N-Methylpyrrolidon oder deren Gemischen, beschichtet und das Lösungsmittel verdampft oder verdunsten läßt. Die Lösung kann man durch Tauchen, Schleudern, Spritzen oder Walzenantrag aufbringen. Der Träger kann beispielsweise aus Kupfer, Aluminium oder einem anderen Metall, Papier, Kunstharz oder Glas bestehen. Der Träger soll so beschichtet werden, daß die Schicht nach dem Trocknen eine Dicke im Bereich von etwa 1 bis 250 µm aufweist. Das Lösungsmittel läßt sich durch Lufttrocknung, durch Erhitzen (auf eine Temperatur unter derjenigen, bei der irgendeine heißhärtbare Komponente härtet) oder nach irgendeiner anderen bekannten Trocknungsmethode entfernen. Der beschichtete Träger kann dann gelagert werden, bis er zum Gebrauch benötigt wird. In gewissen Fällen kann es wünschenswert sein, der Schicht eine gewisse restliche Klebrigkeit zu belassen, um ihre Empfindlichkeit zu erhöhen.

Die bildweise Belichtung erfolgt üblicherweise durch Belichtung der Schicht Resistzusammensetzung mit aktinischer Strahlung durch ein Durchsichtsbild hindurch, das aus weitgehend undurchsichtigen und weitgehend durchsichtigen Stellen besteht. Aktinische Strahlung einer Wellenlänge von 200 bis 600 nm wird im allgemeinen angewandt. Als aktinische Strahlungsquellen eignen sich unter anderem Kohlelichtbögen, Quecksilberdampflichtbögen, Leuchtröhren mit ultraviolettes Licht ausstrahlenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die erforderliche Belichtungszeit hängt von verschiedenen Faktoren ab, beispielsweise der Art des individuellen verwendeten Materials (a), der Schichtdicke, der Art der Strahlungsquelle und ihrem Abstand von der Schicht; sie kann einige Sekunden bis etwa 20 Minuten betragen. Der Abstand zwischen der Lichtquelle und der Photoresistschicht beträgt üblicherweise etwa 3 cm bis etwa 50 cm.

Nach der bildweisen Belichtung wird die Photoresistschicht mit einem Entwickler gewaschen, um den belichteten Teil, d. h. den von der Strahlung getroffenen Teil, zu entfernen und den unbelichteten Teil zurückzulassen. So erhält man eine positive Abbildung. Wie schon gesagt ist die in der Photoresistschicht verwendete polymerisierbare Verbindung (b) vorzugsweise der Art, daß sie den belichteten Teil in einem wäßrigen Entwickler löslich macht.

Die nachfolgende Behandlung des die Abbildung aufweisenden Trägers hängt von ihrem Verwendungszweck ab. Wie bereits angegeben kann bei Verwendung eines heißhärtbaren Harzes als Material (a), insbesondere eines Epoxidharzes zusammen mit einem hitzeaktivierbaren Härter dafür, der unbelichtete Teil der Photoresistschicht durch Erhitzen gehärtet werden, um seine Haftung am Träger zu verbessern.

Das erfindungsgemäße Verfahren ist bei der Herstellung von Druckplatten und gedruckten, integrierten und Hybrid-Schaltkreisen verwendbar.

Eine ein Epoxidharz enthaltende Photoresistschicht ist besonders wertvoll zur Herstellung von mehrschichtigen gedruckten Schaltungen.

Eine mehrschichtige gedruckte Schaltung stellt man gewöhnlich aus mehreren zweiseitig bedruckten, übereinandergestapelten und durch Isolierbögen, üblicherweise aus mit einem Epoxidharz oder einem Phenol/Formaldehydharz in der B-Stufe imprägnierter Glasfaser, voneinander getrennten Leiterplatten aus Kupfer her. Enthält die Photoresistschicht in der Leiterplatte keinen Heißhärter, so kann man diesen in die mit den Platten abwechselnden Isolierschichten einarbeiten, wobei diese Schichten zweckmäßig aus einem Epoxidharz- oder Phenol/Formaldehydharzpräpreg bestehen; ist der Präpreg nicht zu dick, so wandert genügend darin enthaltener Heißhärter aus, um die Vernetzung des Epoxidharzes im unbelichteten Teil der Photoresistschicht einzuleiten. Der Schichtverbund wird durch Erhitzen und Verpressen des Stapels hergestellt.

Die Anwesenheit restlicher Vernetzungsgruppen in den erfindungsgemäßen Zusammensetzungen bedeutet, daß beim Herstellen des Plattenverbunds Vernetzung eintreten kann, was zu guter Haftung am Kupfer und am harzimprägnierten Glasfasersubstrat führt, so daß sich eine Entfernung der Photoresistschicht vor der Herstellung des Plattenverbunds erübrigt.

Die Erfindung wird durch die nachfolgenden Beispiele erläutert. Falls nicht anders angegeben, sind Teile Gewichtsteile.

Die in den Beispielen verwendeten Ausgangsstoffe werden wie folgt hergestellt. Temperaturen sind in Celsiusgraden angegeben. Dünnschichtchromatographie wird auf Siliciumdioxyd unter Verwendung von 80 : 20 (Vol./Vol.) Diäthyläther und Petroläther (Siedepunkt 40° —60°) als Laufmittel durchgeführt.

4,4'-Dihydroxybenzoin-n-butyläther

4,4'-Dihydroxybenzoin wird nach einer von zwei Arbeitsweisen hergestellt und dann an der alkoholischen Hydroxylgruppe butyliert.

Arbeitsweise I

a) 4-(Methoxymethoxy)-benzaldehyd

Dies wird nach Yardley und Fletcher (Synthesis, 1976, 244) hergestellt:

Man rührt eine Suspension von 4-Hydroxybenzaldehyd (55 g) und Toluol-4-sulfonsäure (1,0 g) unter Rückfluß in ein Gemisch aus Dichlormethan (500 ml) und Dimethoxymethan (250 ml) unter einem ein Molekularsieb (100 g) vom Typ 3A enthaltenden Soxhlet-Extraktionsapparat ein. Nach 2 Stunden Rückfluß wird das Molekularsieb durch ein neues Quantum ersetzt und mehr Toluol-4-sulfonsäure (1,0 g) zum Reaktionsgemisch gegeben. Nach 48 Stunden Rückfluß wird das Molekularsieb nochmals ausgewechselt. Nach 66 Stunden fortlaufendem Rückfluß kühlt man das Gemisch und filtriert den suspendierten Feststoff ab. Das Filtrat wird fünfmal mit je 200 ml n-Natronlauge (d. h., bis die Natronlauge nach dem Waschen farblos bleibt) und dann mit Wasser gewaschen und über wasserfreiem $MgSO_4$ getrocknet. Nach Entfernung des Lösungsmittels erhält man 4-(Methoxymethoxy)-benzaldehyd (47 g) als hellbraunes Öl. Dieses wird ohne weitere Reinigung verwendet.

Eine kleine Probe wird durch Vakuumdestillation gereinigt, Siedepunkt 85—6°, 0,25 Torr.

b) 4,4'-Di-(methoxymethoxy)-benzoin

Man erhitzt ein Gemisch aus 4-(Methoxymethoxy)-benzaldehyd (47 g) und Kaliumcyanid (6,5 g) in Wasser (40 ml) und Äthanol (52 ml) unter Rühren $2^1/_2$ Stunden zum Rückfluß. Die entstandene Lösung wird abgekühlt und in eine Lösung von Ammoniumsulfat (300 g) in Wasser (600 ml) gegossen. Man extrahiert mit Diäthyläther, wäscht die ätherische Lösung zweimal mit Wasser und trocknet über wasserfreiem $MgSO_4$. Bei Entfernung des Äthers durch Destillation verbleiben 40 g hellbraunes Öl. Laut Dünnschichtchromatographie besteht dieses Öl aus nicht umgesetztem 4-(Methoxymethoxy)-benzaldehyd und 4,4'-Di-(methoxymethoxy)-benzoin. Das erwünschte Produkt wird dadurch isoliert, daß man das Öl in ein eisgekühltes Gemisch aus Wasser (1900 ml) und Äthanol (400 ml) gießt und den ausgefällten weißen Feststoff (19 g) abfiltriert und trocknet. Dünnschichtchromatographie zeigt, daß der Feststoff fast vollständig aus 4,4'-Di-(methoxymethoxy)-benzoin besteht und das Filtrat 4-(Methoxymethoxy)-benzaldehyd mit nur einer Spur 4,4'-Di-(methoxymethoxy)-benzoin enthält.

Eine Probe des Produkts wird aus Äthanol umkristallisiert. Analyse: C, 65,46%, berechnet für $C_{18}H_{20}O_6$, C, 65,47%. Schmelzpunkt 83,5—84° (H. Kunimoto, Nippon Kagaku Zasshi 1963, 84 [1], 60—4, gibt einen Schmelzpunkt von 75—6° an).

c) 4,4'-Dihydroxybenzoin

Man löst 4,4'-Di-(methoxymethoxy)-benzoin (26 g) in einem 80° warmen Gemisch aus Wasser (250 ml) und Äthanol (250 ml). Man versetzt mit konzentrierter Salzsäure (2,6 g) und rührt 45 Minuten bei 80°. Dann kühlt man ab und gibt eine Lösung von Natriumbicarbonat (2,6 g) in Wasser (50 ml) dazu.

Man gießt in mit Ammoniumsulfat gesättigtes Wasser (600 ml) und extrahiert das entstandene Gemisch mit Äther. Die ätherische Lösung wird über wasserfreiem $MgSO_4$ getrocknet, und bei Entfernung des Äthers durch Destillation verbleiben 19 g dunkelroter Feststoff. Laut Dünnschichtchromatographie besteht dieser im Vergleich mit einer authentischen Probe (siehe weiter unten) im wesentlichen aus 4,4'-Dihydroxybenzoin, und das Material wird ohne weitere Reinigung verwendet.

Arbeitsweise II

a) 4,4'-Dihydroxybenzil

Dies wird nach der von Leonard u. a. in J. Amer. Chem. Soc., 1949, 71, 2997, beschriebenen Methode hergestellt.

Durch Oxydation von Anisoin mit Kupfersulfat in Pyridin hergestelltes Anisil (6,5 g) wird in Essigsäure (50 g) gegeben und zwecks Auflösung zum Rückfluß erhitzt. Unter Rückfluß versetzt man mit Bromwasserstoffsäure (Dichte 1,48), bis Anisil eben auszufallen beginnt (dazu werden etwa 30 ml HBr benötigt). Nach 2 Stunden Rückfluß gibt man mehr Bromwasserstoffsäure (50 ml) dazu und erhitzt die Lösung noch 2 Stunden zum Rückfluß. Danach zeigt Dünnschichtchromatographie vollständige Umsetzung zu einem einheitlichen Produkt. Man gießt die Lösung in kaltes Wasser (600 ml), wobei ein weißer Feststoff ausfällt. Dieser wird abfiltriert, mit Wasser gewaschen und getrocknet, wobei man 5,5 g 4,4'-Dihydroxybenzil erhält. Dieses wird ohne weitere Reinigung verwendet.

b) 4,4'-Dihydroxybenzoin

Man gibt konzentrierte Salzsäure (12,5 ml) unter kräftigem Rühren bei 70° zu einer Suspension von 4,4'-Dihydroxybenzil (5,0 g) und Zinn (0,8 mm, 2,75 g) in Wasser (250 ml). Nach einigen Minuten bildet sich eine klare Lösung. Nach insgesamt 8 Minuten Reaktionszeit wird die Lösung heiß filtriert. Man gibt Ammoniumsulfat (50 g) zum Filtrat; beim Abkühlen fällt ein weißer Feststoff aus. Dieser wird abfiltriert, mit Wasser gewaschen und getrocknet, was 3,8 g Produkt ergibt. Laut Dünnschichtchromatographie ist dies im wesentlichen 4,4'-Dihydroxybenzoin, das ohne weitere Reinigung verwendet wird. Eine aus Wasser umkristallisierte kleine Probe zeigt einen Schmelzpunkt von 176—177° C.

III. n-Butylierung des 4,4'-Dihydroxybenzoins

Man löst 4,4'-Dihydroxybenzoin (18 g) in einem Gemisch aus n-Butanol (250 ml) und Xylol (125 ml) und erhitzt zum Rückfluß unter einem Aufsatz nach Dean und Stark. Man gibt Toluol-4-sulfonsäure (1,2 g) dazu und erhitzt das Gemisch 45 Minuten unter Rückfluß, wonach sich in der Falle kein Wasser mehr abscheidet. Die Lösung wird abgekühlt, mit Wasser, verdünnter Natriumbicarbonatlösung und nochmals mit Wasser gewaschen und dann über wasserfreiem $MgSO_4$ getrocknet. Nach Entfernung des Lösungsmittels erhält man 19 g dunkles Öl. Das Produkt wird durch Zusatz von Toluol (350 ml) und Erhitzen zum Rückfluß gereinigt, wobei sich eine klare, hellgefärbte Lösung ergibt. Die Lösung wird von einer geringen Menge (etwa 1,5 g) teerigem Rückstand abgegossen; beim Abkühlen scheidet sich ein weißer kristalliner Feststoff aus. Dieser wird abfiltriert und getrocknet, wobei man 13,5 g 4,4'-Dihydroxybenzoin-n-butyläther, Schmelzpunkt 164—5°, erhält. Analyse: C = 71,81; berechnet für $C_{18}H_{12}O_4$, C = 72,00.

Lösung A

Man rührt eine Lösung von 4,4'-Dihydroxybenzoin-n-butyläther (3,0 g), 1,4-Butandiol-diglycidyläther (Epoxidgehalt 8,64 val/kg, 2,85 g) und N-Benzyldimethylamin (0,03 g) in 2-Äthoxyäthanol (12 g) $2^1/_2$ Stunden bei 130°, wonach der Epoxidgehalt des gelösten Stoffs auf 0,80 val/kg gefallen ist. Diese Lösung eines vorverlängerten Epoxidharzes wird weiter unten als »Lösung A« bezeichnet.

Lösung B

Man rührt eine Lösung von 4,4'-Dihydroxybenzoin-n-butyläther (3,0 g), Bisphenol-A-diglycidyläther mit 5,2 val/kg Epoxidgehalt (4,3 g) und N-Benzyldimethylamin (0,03 g) in 2-Äthoxyäthanol 2 Stunden bei 130°, wonach der Epoxidgehalt des gelösten Stoffs auf 0,35 val/kg gefallen ist. Diese Lösung eines vorverlängerten Epoxidharzes ist »Lösung B«.

Lösung C

Man löst N,N'-Diglycidyl-5,5-dimethylhydantoin mit 7,88 val/kg Epoxidgehalt (3,0 g), 4,4-Dihydroxybenzoin-n-butyläther (3,4 g) und N-Benzyldimethylamin (0,02 g) in 2-Äthoxyäthanol (15 g) und rührt 2 Stunden bei 135° C, wonach der Epoxidgehalt des gelösten Stoffs auf 0,65 val/kg gefallen ist. Diese Lösung eines vorverlängerten Epoxidharzes ist »Lösung C«.

Lösung D

Man löst gemäß US-Patentschrift 4 001 216 hergestelltes 3,3'-Dihydroxybenzoin (3,5 g), 1,4-Butandioldiglycidyläther (Epoxidgehalt 8,64 val/kg, 3,2 g) und N-Benzyldimethylamin (16 g) in 2-Äthoxyäthanol (16 g) und rührt $3^1/_2$ Stunden bei 120°, wonach der Epoxidgehalt des gelösten Stoffs auf 0,34 val/kg gefallen ist. Diese Lösung eines vorverlängerten Epoxidharzes ist »Lösung D«.

Lösung E

Unter Rühren tropft man eine Lösung von Triäthylamin (2,2 g) in trockenem Cyclohexanon (5 g) bei 80° zu einer Lösung von 4,4'-Dihydroxybenzoin-n-butyläther (4,0 g) und frisch destilliertem Adipoylchlorid (2,2 g) in trockenem Cyclohexanon (15 g). Nach der Zugabe rührt man $^1/_2$ Stunde bei 80°, kühlt dann auf Raumtemperatur und filtriert das Aminsalz ab. Das Filtrat, die Lösung eines Polyesters, wird weiter unten als »Lösung E« bezeichnet.

Lösung F

Nach der in US-Patentschrift 3 728 377 beschriebenen Methode, wobei es sich um eine Benzoinkondensation und nachfolgende gleichzeitige Verätherung und Umesterung mit Äthanol/Chlorwasserstoff handelt, wird 4,4'-Bis-(äthoxycarbonyl)-benzoin-äthyläther aus p-Formylbenzoesäuremethylester hergestellt. Durch 1 Stunde Erhitzen von 25 g dieses Äthers mit 12,1 g Triäthylenglykol auf 180° C unter Rühren in Gegenwart von 0,04 g Titantetrabutylat, Auffangen des freigesetzten Äthanols und danach langsame Erniedrigung des Drucks auf etwa 15 Torr erhält man einen Polyester. Nach 1 Stunde Erhitzen bei 180° C unter etwa 15 Torr Vakuum entwickelt sich kein Äthanol mehr. Der verbleibende Polyester wird in 45 g 2-Äthoxyäthanol gelöst, was »Lösung F« ergibt.

Lösung G

Man tropft eine Lösung von 8,07 g handelsüblichem Präpolymer aus 2,4- und 2,6-Diisocyanatotoluol mit Polytetrahydrofuran (Isocyanatgehalt 9,37%) in Toluol (10 g) bei 20° C zu 6,29 g 4,4'-Dihydroxybenzoin-n-butyläther in 18,72 g Toluol, das 0,2 g Dibutylzinndilaurat enthält. Man erwärmt auf 60° C und rührt 9 Stunden, wonach der Isocyanatgehalt vernachlässigbar ist. Toluol (12,8 g) wird bei vermindertem Druck abdestilliert und durch die gleiche Gewichtsmenge 2-Äthoxyäthanol ersetzt, um eine homogene Lösung, »Lösung G«, zu bilden.

Lösung H

Man rührt ein Gemisch aus 4,4'-Dihydroxybenzoin-n-butyläther (5,0 g), 1,4-Butandiol-diglycidyläther (Epoxidgehalt 8,64 val/kg, 3,5 g), N,N'-Diglycidyl-5,5-dimethylhydantoin (Epoxidgehalt 7,88 val/kg, 1,4 g), Tetramethylammoniumchlorid (0,02 g) und 2-Äthoxyäthanol (20,0 g) 2 Stunden bei 135° C, wonach der Epoxidgehalt des gelösten Stoffs auf 0,70 val/kg gefallen ist. Diese Lösung eines vorverlängerten Epoxidharzes ist »Lösung H«.

Lösung 1

Man rührt eine Lösung von Trimellithsäureanhydrid (15,7 g), 2-Hydroxyäthylacrylat (10,0 g), Hydrochinon (0,1 g), Benzochinon (0,1 g) und N-Benzyldimethylamin (0,1 g) in trockenem Cyclohexanon (40 g) 3 Stunden bei 100°, wonach das Infrarotspektrum der Lösung nur noch eine Spur Anhydrid anzeigt: diese Lösung von 1,4-Dicarboxy-2-(acryloyloxy)-äthylcarbonyloxybenzol ist »Lösung 1«.

Lösung 2

Man rührt eine Lösung von Phthalsäureanhydrid (14,8 g), 2-Hydroxyäthylacrylat (11,8 g), Hydrochinon (0,1 g), Benzochinon (0,1 g) und N-Benzyldimethylamin (0,1 g) in trockenem Cyclohexanon (30 ml) 5 Stunden bei 95—100°, wonach das Infrarotspektrum der Lösung nur noch eine Spur Anhydrid anzeigt. Diese Lösung von 2-(Acryloyloxy)-äthyl-hydrogenphthalat ist »Lösung 2«.

Lösung 3

Man rührt eine Lösung von Bernsteinsäureanhydrid (10,0 g), 2-Hydroxyäthylacrylat (11,6 g), N-Benzyldimethylamin (0,2 g), Hydrochinon (0,1 g) und Benzochinon (0,1 g) in trockenem Cyclohexanon (30 g) 4 Stunden bei 100°, wonach das Infrarotspektrum der Lösung zeigt, daß praktisch alles Anhydrid umgesetzt ist. Diese Lösung von 2-(Acryloyloxy)-äthyl-hydrogensuccinat ist »Lösung 3«.

Lösung 4

Diese wird in der gleichen Weise wie Lösung 1 hergestellt, außer daß man statt Cyclohexanon eine gleiche Gewichtsmenge N-Methylpyrrolidon einsetzt.

Die Lösungen werden durch Aufschleudern bei 2000 U.p.M. auf die Substrate aufgebracht.

Beispiel 1

Man beschichtet ein kupferkaschiertes Laminat mit einem Gemisch aus Lösung A (1,0 g) und Lösung 1 (0,4 g) und läßt das Lösungsmittel verdunsten. Der Film wird durch ein Negativ hindurch 15 Minuten lang mit einer 500-Watt-Mitteldruckquecksilberlampe im Abstand von 23 cm bestrahlt. Nach der Bestrahlung wird die Abbildung durch Waschen mit 0,5%iger Lösung von Dinatriumhydrogenphosphat in Wasser bei 20° entwickelt; die belichteten Stellen der Beschichtung werden so entfernt. Die unbeschichteten Kupferstellen werden dann mit einer wäßrigen, konzentrierte Salzsäure (10% Vol./Vol.) enthaltenden Ferrichloridlösung (60% Gew./Vol. $FeCl_3$) geätzt, wobei eine gute Reliefabbildung zurückbleibt.

Beispiel 2

Man beschichtet ein Kupferlaminat mit einem Gemisch aus Lösung A (1,0 g) und Lösung 2 (0,4 g) und prüft wie in Beispiel 1 beschrieben. Nach 3 Minuten Bestrahlung sowie Entwicklung in 0,3%igem wäßrigem Natriumcarbonat erhält man eine gute Reliefabbildung.

Beispiel 3

Man beschichtet ein Kupferlaminat mit einem Gemisch aus Lösung A (1,0 g) und Lösung 3 (0,2 g) und prüft wie in Beispiel 1 beschrieben. Nach 1 Minute Bestrahlung sowie Entwicklung in 0,1%igem wäßrigem Natriumcarbonat erhält man eine gute Reliefabbildung.

Beispiel 4

Man beschichtet ein kupferkaschiertes Laminat mit einem Gemisch aus Lösung B (1,0 g) und Lösung 3 (0,2 g) und läßt trocknen. Die Beschichtung wird durch eine Maske hindurch unter einer Lampe (80 W pro cm) im Abstand von 125 mm bestrahlt. Nach 20 Sekunden Bestrahlung sowie Entwicklung in 2%iger Natronlauge erhält man eine gute Reliefabbildung.

Beispiel 5

Man beschichtet ein kupferkaschiertes Laminat mit einem Gemisch aus Lösung C (1,0 g) und Lösung 2 (0,4 g) und läßt trocknen. Die Beschichtung wird wie in Beispiel 4 beschrieben geprüft. Nach 20 Sekunden Bestrahlung sowie Entwicklung in 2%iger wäßriger Natriumcarbonatlösung erhält man eine gute Reliefabbildung.

## Beispiel 6

Man beschichtet ein kupferkaschiertes Laminat mit einem Gemisch aus Lösung D (0,5 g) und Lösung 3 (0,3 g) und prüft gemäß Beispiel 4. Nach 40 Sekunden Betrahlung sowie Entwicklung in 2%iger Natriumcarbonatlösung erhält man eine gute Reliefabbildung.

## Beispiel 7

Man bringt ein Gemisch aus Lösung E (0,5 g) und Lösung 1 (0,2 g) auf ein kupferkaschiertes Laminat auf und läßt trocknen. Die Beschichtung wird wie in Beispiel 4 beschrieben geprüft. Nach 20 Sekunden Bestrahlung sowie Entwicklung in 0,5%iger wäßriger Dinatriumhydrogenphosphatlösung erhält man eine gute Reliefabbildung.

## Beispiel 8

Wie in Beispiel 1 beschrieben erzeugt man eine Reliefabbildung. Die Beschichtung auf den unbestrahlten Stellen wird durch 2 Stunden Erhitzen auf 160° gehärtet. Vor dem Erhitzen war die Beschichtung in Aceton leicht löslich. Die heißgehärtete Beschichtung widersteht jedoch mehr als 20maligem Reiben mit einem in Aceton getränkten Wattebausch.

## Beispiel 9

Man beschichtet ein kupferkaschiertes Laminat mit einem Gemisch aus Lösung C (1,0 g) und 3-Butensäure (0,30 g) und trocknet durch 10 Minuten Erhitzen auf 80° C. Die Beschichtung wird durch eine Maske hindurch unter einer 500-Watt-Mitteldruckquecksilberlampe im Abstand von 230 mm bestrahlt. Nach 5 Minuten Bestrahlung sowie Entwicklung in 0,1 n-Natronlauge erhält man eine gute Reliefabbildung.

## Beispiel 10

Man beschichtet ein kupferkaschiertes Laminat mit einem Gemisch aus Lösung C (1,0 g) und 2-(Dimethylamino)-äthylmethacrylat (0,30 g) und läßt trocknen. Die Beschichtung wird wie in Beispiel 9 beschrieben bestrahlt. Nach 5 Minuten Bestrahlung sowie Entwicklung in 0,1 n-Salzsäure erhält man eine gute Reliefabbildung.

## Beispiel 11

Man beschichtet ein kupferkaschiertes Laminat mit einem Gemisch aus Lösung A (1,0 g) und Maleinsäure (0,03 g) und trocknet durch 10 Minuten Erhitzen auf 80° C. Die Beschichtung wird wie in Beispiel 1 beschrieben geprüft. Nach 5 Minuten Bestrahlung sowie Entwicklung in 0,3%iger wäßriger Natriumcarbonatlösung erhält man eine gute Reliefabbildung.

## Beispiel 12

Man beschichtet ein kupferkaschiertes Laminat mit einem Gemisch aus Lösung F (0,5 g) und Lösung 1 (0,25 g) und trocknet. Die Beschichtung wird wie in Beispiel 4 beschrieben geprüft. Nach 10 Sekunden Bestrahlung sowie Entwicklung in 0,5%iger wäßriger Natriumcarbonatlösung erhält man eine gute Reliefabbildung.

## Beispiel 13

Man beschichtet ein kupferkaschiertes Laminat mit einem Gemisch aus Lösung G (0,5 g) und Lösung 4 (0,25 g) und trocknet durch 10 Minuten Erhitzen auf 80° C. Nach 10 Minuten Bestrahlung durch ein Negativ hindurch mit der Strahlung einer Quecksilberlampe (30 W pro cm) entwickelt man mit 1%iger wäßriger Natriumcarbonatlösung. Man erhält eine positive Abbildung.

Beispiel 14

Man bringt ein Gemisch aus Lösung G (3 g) und 2-(Dimethylamino)-äthylacrylat (1 g) auf ein kupferkaschiertes Laminat auf, trocknet und bestrahlt wie in Beispiel 13. Bei Entwicklung mit 0,1 m-Salzsäure erhält man eine positive Abbildung.

Beispiel 15

Man bringt einen Anteil eines Gemischs aus Lösung H (3,0 g), Lösung C (1,5 g) und 2-(Dimethylamino)-äthylacrylat (1,0 g) auf ein kupferkaschiertes Laminat auf, trocknet bei Raumtemperatur und bestrahlt wie in Beispiel 13. Bei Entwicklung mit 0,1 m-Salzsäure erhält man eine positive Abbildung. Nach weiterem Erhitzen für 1 Stunde auf 120°C widersteht die Abbildung zweimaligem Reiben mit einem in Aceton getränkten Wattebausch.

Zu einem weiteren Anteil desselben Gemischs (2,0 g) gibt man 0,1 g n-Octyldimethylamin-bortrifluoridkomplex. Dieses Gemisch wird auf ein kupferkaschiertes Laminat aufgebracht und derselben Verarbeitung wie das keinen Bortrifluoridkomplex enthaltende Gemisch unterzogen. So erhält man eine positive Abbildung, die fünfmaligem Reiben mit der in Aceton getränkten Watte widersteht.

**Patentansprüche**

1. Verfahren zur Erzeugung von Abbildungen, wobei man eine positive Photoresistzusammensetzung mit aktinischer Strahlung bildweise belichtet und danach die Zusammensetzung mit einem Entwickler behandelt, um den belichteten Teil zu entfernen, dadurch gekennzeichnet, daß die Photoresistzusammensetzung besteht aus: (a) einem filmbildenden organischen Material mit mindestens einer substituierten Benzoingruppe der Formel

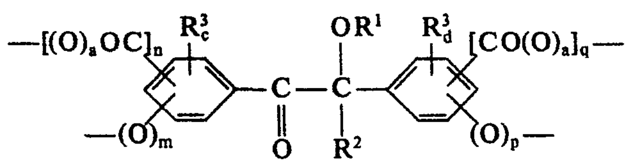

(I)

worin $R^1$ für ein Wasserstoffatom, eine Alkyl-, Cycloalkyl-, Cycloalkylalkyl- oder Aralkylgruppe oder eine Gruppe $-(CH_2)_bX$, $R^2$ für ein Wasserstoffatom oder eine Alkyl-, Cycloalkyl-, Cycloalkylalkyl-, Aryl- oder Aralkylgruppe, $R^3$ für ein Halogenatom oder eine Alkyl-, Alkoxy-, Cycloalkyl-, Cycloalkylalkyl- oder Phenylgruppe, X für ein Halogenatom, für eine Alkoxygruppe, eine Phenoxygruppe, eine Gruppe $-COOR^4$ oder eine Gruppe $-OOCR^4$ und $R^4$ für eine Alkylgruppe stehen sowie a Null oder 1, b eine ganze Zahl von 1 bis 4, m Null oder 1, n Null oder 1, wobei die Summe von $m+n = 1$ ist, p Null oder 1, q Null oder 1, wobei die Summe von $p+q = 1$ ist, c Null oder eine ganze Zahl von 1 bis 3 und d Null oder eine ganze Zahl von 1 bis 3 sind, und (b) einer Verbindung, die unter der Einwirkung eines Radikalkatalysators zu höhermolekularem Material polymerisierbar ist, das in einem Entwickler löslicher ist als die Zusammensetzung vor der Belichtung, so daß die Löslichkeit der Zusammensetzung im Entwickler in dem belichteten Teil zunimmt.

2. Verfahren nach Anspruch 2, dadurch gekennzeichnet, daß $R^1$ für eine Alkylgruppe mit 1 bis 12 Kohlenstoffatomen, eine Cycloalkylgruppe mit 3 bis 8 Kohlenstoffatomen, eine Cycloalkylalkylgruppe mit 4 bis 10 Kohlenstoffatomen, eine Aralkylgruppe mit 7 bis 16 Kohlenstoffatomen oder eine Gruppe $-(CH_2)_bX$ steht, wobei X ein Chlor- oder Bromatom, eine Alkoxygruppe mit 1 bis 4 Kohlenstoffatomen, eine Gruppe der Formel $-COOR^4$ oder der Formel $-OOCR^4$ bedeutet, wobei $R^4$ eine Alkylgruppe mit 1 bis 4 Kohlenstoffatomen darstellt und b 1, 2 oder 3 ist.

3. Verfahren nach Anspruch 1, dadurch gekennzeichnet, daß $R^1$ für ein Wasserstoffatom oder eine Alkylgruppe mit 1 bis 4 Kohlenstoffatomen steht.

4. Verfahren nach einem der vorhergehenden Ansprüche, dadurch gekennzeichnet, daß $R^2$ für eine Alkylgruppe mit 1 bis 12 Kohlenstoffatomen, eine Cycloalkylgruppe mit 3 bis 8 Kohlenstoffatomen, eine Cycloalkylalkylgruppe mit 4 bis 10 Kohlenstoffatomen, eine Aralkylgruppe mit 7 bis 16 Kohlenstoffatomen oder eine Arylgruppe mit 6 bis 12 Kohlenstoffatomen steht.

5. Verfahren nach einem der Ansprüche 1 bis 3, dadurch gekennzeichnet, daß $R^2$ für ein Wasserstoffatom oder für eine Alkylgruppe mit 1 bis 4 Kohlenstoffatomen steht.

6. Verfahren nach einem der vorhergehenden Ansprüche, dadurch gekennzeichnet, daß als filmbildendes Material (a) ein Polyurethan, ein Polyamid, ein Polycarbonat, ein Polysulfon, ein Phenoxyharz, ein Epoxidharz oder ein Polyester vorliegt.

7. Verfahren nach Anspruch 6, dadurch gekennzeichnet, daß als filmbildendes Material (a) ein Epoxidharz der Formel

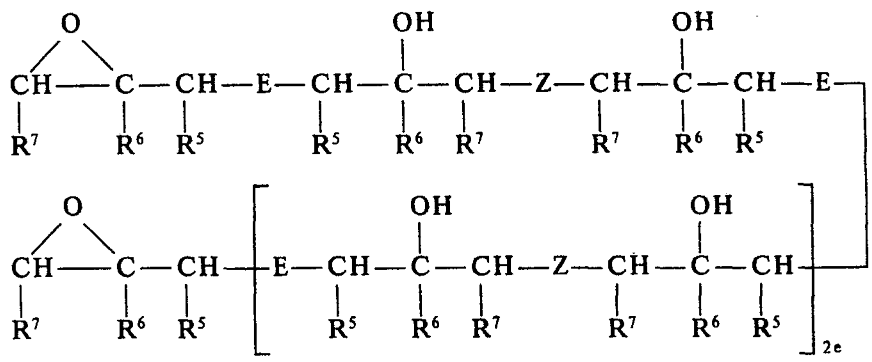

(III)

worin E den Rest eines Diepoxids nach Wegnahme zweier Gruppen der Formel

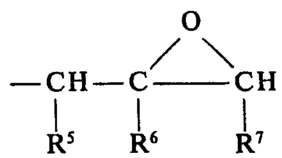

(IV)

darstellt, wobei dieser Rest über Sauerstoff-, Stickstoff- oder Schwefelatome an die angegebenen Kohlenstoffatome gebunden ist, Z eine Gruppe der Formel I mit $a = 1$ bedeutet, $R^5$ und $R^7$ entweder beide für ein Wasserstoffatom stehen, wobei $R^6$ dann ein Wasserstoffatom oder eine Methylgruppe bedeutet, oder zusammen für $-CH_2CH_2-$ stehen, wobei $R^6$ dann ein Wasserstoffatom bedeutet, und e Null oder eine ganze Zahl von 1 bis 50 ist, vorliegt.

8. Verfahren nach Anspruch 6, dadurch gekennzeichnet, daß als filmbildendes Material (a) ein durch Umsetzung einer Verbindung der Formel

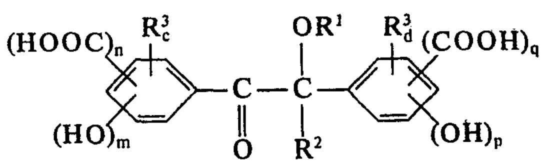

(II)

worin $R^1$, $R^2$, $R^3$, x und y die in Anspruch 1 angegebenen Bedeutungen haben, mit einer aliphatischen Dicarbonsäure bzw. einem esterbildenden Derivat davon, falls m und p je 1 sowie n und q je Null sind, oder durch Umsetzung der Verbindung bzw. eines esterbildenden Derivats davon, mit einem zweiwertigen Alkohol oder einem zweiwertigen Phenol, falls n und q je 1 sowie m und p je Null sind, erhaltener Polyester vorliegt.

9. Verfahren nach Anspruch 6, dadurch gekennzeichnet, daß als filmbildendes Material (a) ein durch Umsetzung einer Verbindung der Formel

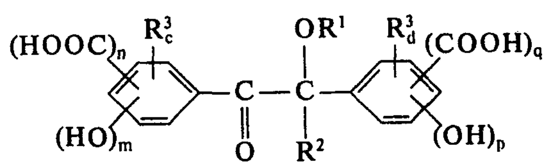

(II)

worin $R^1$, $R^2$, $R^3$, x und y die in Anspruch 1 angegebenen Bedeutungen haben, und m und p je 1 sowie n und q je Null sind, mit einem aliphatischen, cacloaliphatischen, aromatischen, araliphatischen oder heterocyclisch-aliphatischen Diisocyanat oder dessen Präpolymer erhaltenes Polyurethan vorliegt.

10. Verfahren nach einem der vorhergehenden Ansprüche, dadurch gekennzeichnet, daß (b) zu einem höhermolekularen, in wäßrig-alkalischem Entwickler löslichen Material polymerisierbar ist.

11. Verfahren nach einem der Ansprüche 1 bis 9, dadurch gekennzeichnet, daß (b) zu einem höhermolekularen, in wäßrig-saurem Entwickler löslichen Material polymerisierbar ist.

12. Verfahren nach Anspruch 10, dadurch gekennzeichnet, daß (b) eine äthylenisch ungesättigte Gruppe und eine oder mehrere Carboxylgruppen enthält.

13. Verfahren nach Anspruch 12, dadurch gekennzeichnet, daß als äthylenisch ungesättigte Gruppe eine Acryloyloxy- oder Methacryloyloxygruppe vorliegt.

14. Verfahren nach Anspruch 11, dadurch gekennzeichnet, daß (b) eine äthylenisch ungesättigte Gruppe und eine oder mehrere Aminogruppen enthält.

15. Verfahren nach Anspruch 14, dadurch gekennzeichnet, daß als (b) ein Alkylaminoalkylacrylat oder -methacrylat, ein Dialkylaminoalkylacrylat oder -methacrylat oder ein Vinylpyridin vorliegt.

16. Verfahren nach einem der vorhergehenden Ansprüche, dadurch gekennzeichnet, daß diese Zusammensetzung mindestens 1 Mol (b) pro Gruppe der Formel I in (a) enthält.

## Claims

1. Process for the formation of images which comprises exposing image-wise to actinic radiation a positive photoresist composition and subsequently treating the composition with a developer to remove the exposed portion, characterised in that the photoresist composition consists of: (a) a film-forming organic material having at least one substituted benzoin group of the formula

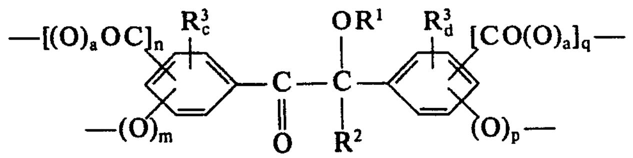

(I)

wherein $R^1$ is a hydrogen atom, an alkyl, cycloalkyl, cycloalkylalkyl or aralkyl group, or a group $-(CH_2)_bX$, $R^2$ is a hydrogen atom or an alkyl, cycloalkyl, cycloalkylalkyl, aryl or aralkyl group, $R^3$ is a halogen atom or an alkyl, alkoxy, cycloalkyl, cycloalkylalkyl or phenyl group, X is a halogen atom, an alkoxy group, a phenoxy group, a group $-COOR^4$ or a group $-OOCR^4$, $R^4$ is an alkyl group, a is zero or 1, b is an integer from 1 to 4, m is zero or 1, n is zero or 1, the sum of m+n being 1, p is zero or 1, q is zero or 1, the sum of p+q being 1, c is zero or an integer from 1 to 3, and d is zero or an integer from 1 to 3; and (b) a compound which is polymerisable under the influence of a free radical catalyst to form a higher molecular weight material which is more soluble in a developer than the composition prior to exposure, so that the solubility of the composition in the developer is increased in the exposed portion.

2. Process according to claim 2, characterised in that $R^1$ is an alkyl group having 1 to 12 carbon atoms, a cycloalkyl group having 3 to 8 carbon atoms, a cycloalkylalkyl group having 4 to 10 carbon atoms, an aralkyl group having 7 to 16 carbon atoms, or a group $-(CH_2)_bX$, wherein X is a chlorine or bromine atom, an alkoxy group having 1 to 4 carbon atoms, a group of the formula $-COOR^4$ or of the formula $-OOCR^4$, wherein $R^4$ is an alkyl group having 1 to 4 carbon atoms, and b is 1, 2 or 3.

3. Process according to claim 1, characterised in that $R^1$ is a hydrogen atom or an alkyl group having 1 to 4 carbon atoms.

4. Process according to any one of the preceding claims, characterised in that $R^2$ is an alkyl group having 1 to 12 carbon atoms, a cycloalkyl group having 3 to 8 carbon atoms, a cycloalkylalkyl group having 4 to 10 carbon atoms, an aralkyl group having 7 to 16 carbon atoms, or an aryl group having 6 to 12 carbon atoms.

5. Process according to any one of claims 1 to 3, characterised in that $R^2$ is a hydrogen atom or an alkyl group having 1 to 4 carbon atoms.

6. Process according to any one of the preceding claims, characterised in that the film-forming material (a) is a polyurethane, a polyamide, a polycarbonate, a polysulfone, a phenoxy resin, an epoxide resin or a polyester.

7. Process according to claim 6, characterised in that the film-forming material (a) is an epoxide resin of the formula

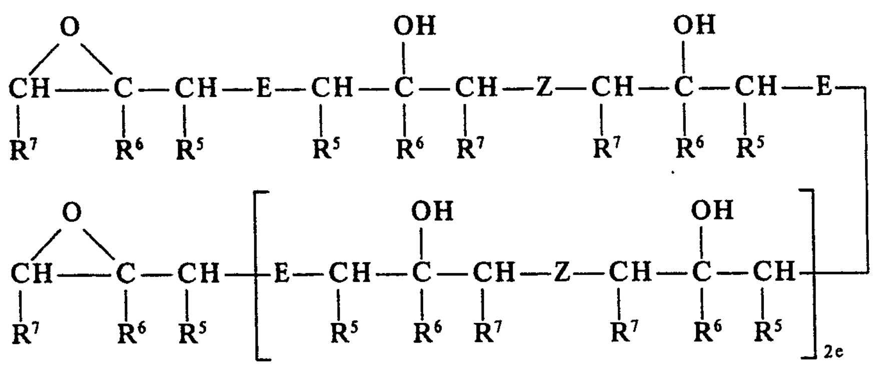

(III)

wherein E is the radical of a diepoxide after removal of two groups of the formula

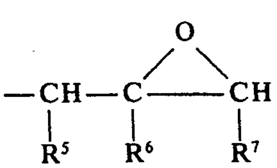

(IV)

this radical being linked by way of oxygen, nitrogen or sulfur atoms to the indicated carbon atoms, Z is a group of the formula I where a = 1, $R^5$ and $R^7$ are either each a hydrogen atom, in which case $R^6$ is a hydrogen atom or a methyl group, or together are $-CH_2CH_2K-$, in which case $R^6$ is a hydrogen atom, and e is zero or an integer from 1 to 50.

8. Process according to claim 6, characterised in that the film-forming material (a) is a polyester obtained by reaction of a compound of the formula

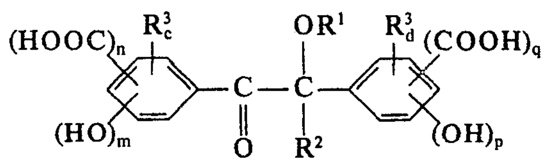

(II)

wherein $R^1$, $R^2$, $R^3$, x and y have the meanings defined in claim 1, with an aliphatic dicarboxylic acid or an ester-forming derivative thereof, if m and p are each 1 and n and q each zero, or by reaction of the compound, or of an ester-forming derivative thereof, with a bivalent alcohol or a bivalent phenol, if n and q are each 1 and m and p each zero.

9. Process according to claim 6, characterised in that the film-forming material (a) is a polyurethane obtained by reaction of a compound of the formula

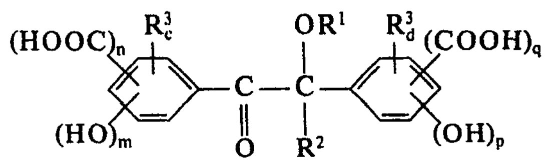

(II)

wherein $R^1$, $R^2$, $R^3$, x and y have the meanings defined in claim 1, and m and p are each 1 and n and q each zero, with an aliphatic, cycloaliphatic, aromatic, araliphatic or heterocyclic-aliphatic diisocyanate or the prepolymer thereof.

10. Process according to any one of the preceding claims, characterised in that (b) is polymerisable to form a higher molecular weight material which is soluble in an aqueous-alkaline developer.

11. Process according to any one of claims 1 to 9, characterised in that (b) is polymerisable to form a higher molecular weight material which is soluble in an aqueous acidic developer.

12. Process according to claim 10, characterised in that (b) contains an ethylenically unsaturated group and one or more carboxyl groups.

13. Process according to claim 12, characterised in that the ethylenically unsaturated group is an acryloyloxy or methacryloyloxy group.

14. Process according to claim 11, characterised in that (b) contains an ethylenically unsaturated group and one or more amino groups.

15. Process according to claim 14, characterised in that (b) is an alkylaminoalkylacrylate or -methacrylate, a dialkylaminoalkylacrylate or -methacrylate or a vinylpyridine.

16. Process according to any one of the preceding claims, characterised in that this composition contains at least 1 mol of (b) per group of the formula I in (a).

**Revendications**

1. Procédé de production d'images dans lequel on irradie par un rayonnement actinique une composition de photoréserve positive, puis on traite cette composition avec un révélateur pour éliminer la partie qui n'a pas été irradiée, procédé caractérisé en ce que la composition de la photoréserve comprend: (a) une matière organique filmogène ayant au moins un groupe de benzoïne substitué de formule

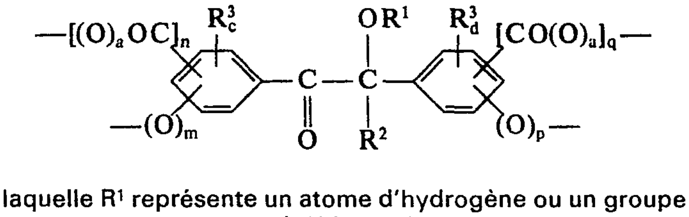

(I)

(dans laquelle $R^1$ représente un atome d'hydrogène ou un groupe alkyle, cycloalkyle, cycloalkylalkyle, ou aralkyle ou un groupe $-(CH_2)_bX$, $R^2$ représente un atome d'hydrogène ou un groupe alkyle, cycloalkyle, cycloalkylalkyle, aryle ou aralkyle, $R^3$ un atome d'halogène ou un groupe alkyle, alcoxy, cycloalkyle, cycloalkylalkyle ou phényle, X un atome d'halogène, un groupe alcoxy ou phénoxy ou un groupe $-COOR^4$ ou $-OOCR^4$, $R^4$ étant un alkyle, et a est le nombre 0 ou 1, b un entier de 1 à 4, m et n sont chacun le nombre 0 ou 1, la somme m+n étant égale à 1, p et q sont chacun le nombre 0 ou 1, la

somme p+q étant égale à 1, c est un entier de 0 à 3 et d est également un entier de 0 à 3), et (b) un composé pouvant être polymérisé sous l'action d'un catalyseur radicalaire en une matière macromoléculaire qui est plus soluble dans un révélateur que la composition avant l'irradiation de celle-ci, de manière à accroître la solubilité dans le révélateur de la partie de la composition qui a été irradiée.

2. Procédé selon la revendication 1, caractérisé en ce que, dans la formule donnée, $R^1$ est un alkyle en $C_1$ à $C_{12}$, un cycloalkyle en $C_3$ à $C_8$, un cycloalkylalkyle en $C_4$ à $C_{10}$, un aralkyle en $C_7$ à $C_{16}$ ou un groupe $-(CH_2)_bX$, X étant un atome de chlore ou de brome, un groupe alcoxy en $C_1$ à $C_4$ ou un groupe $-COOR^4$ ou $-OOCR^4$, $R^4$ étant un alkyle en $C_1$ à $C_4$, et b étant le nombre 1, 2 ou 3.

3. Procédé selon la revendication 1, caractérisé en ce que dans la formule donnée $R^1$ est un atome d'hydrogène ou un alkyle en $C_1$ à $C_4$.

4. Procédé selon l'une quelconque des revendications précédentes, caractérisé en ce que dans la formule donnée $R^2$ est un alkyle en $C_1$ à $C_{12}$, un cycloalkyle en $C_3$ à $C_8$, un cycloalkylalkyle en $C_4$ à $C_{10}$, un aralkyle en $C_7$ à $C_{16}$ ou un aryle en $C_6$ à $C_{12}$.

5. Procédé selon l'une quelconque des revendications 1 à 3, caractérisé en ce que dans la formule donnée $R^2$ est un atome d'hydrogène ou un alkyle en $C_1$ à $C_4$.

6. Procédé selon l'une quelconque des revendications précédentes, caractérisé en ce que la matière filmogène (a) est un polyuréthane, un polyamide, un polycarbonate, une polysulfone, une résine phénoxy, une résine époxyde ou un polyester.

7. Procédé selon la revendication 6, caractérisé en ce que la matière filmogène (a) est une résine époxyde de formule

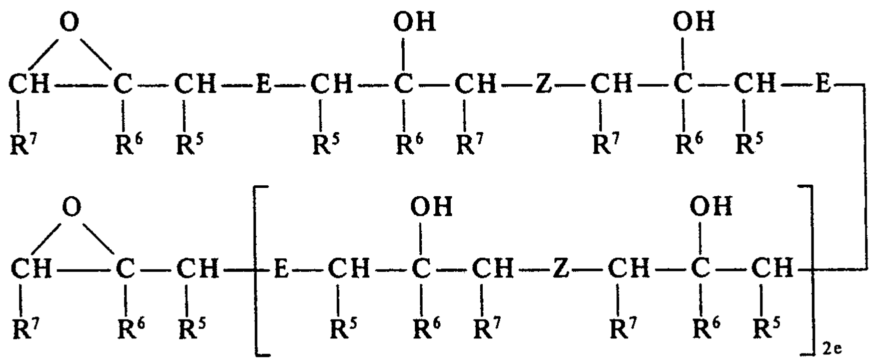

(III)

dans laquelle E est le radical d'un diépoxyde résultant de l'élimination de deux groupes de formule

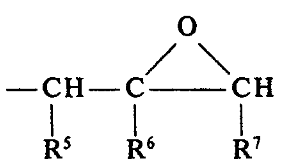

(IV)

radical qui est relié aux atomes de carbone indiqués par des atomes d'oxygène, d'azote ou de soufre, Z est un groupe de formule I avec a = 1, $R^5$ et $R^7$ sont ou bien chacun l'hydrogène, $R^6$ étant alors l'hydrogène ou un méthyle, ou bien forment ensemble un groupe $-CH_2CH_2-$, $R^6$ étant alors l'hydrogène, et e est un entier de 0 à 50.

8. Procédé selon la revendication 6, caractérisé en ce que la matière filmogène (a) est un polyester obtenu par réaction d'un composé de formule

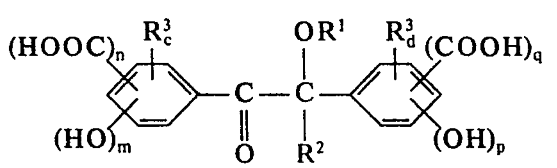

(II)

(dans laquelle $R^1$, $R^2$, $R^3$ ont les significations données dans la revendication 1) avec un acide dicarboxylique aliphatique ou un dérivé de cet acide pouvant former un ester, si m et p sont chacun le nombre 1 et n et q sont tous deux nuls, ou bien par réaction de ce composé ou de son dérivé pouvant former un ester avec un dialcool ou un diphénol si n et q sont chacun le nombre 1 et m et p sont tous les deux nuls.

9. Procédé selon la revendication 6, caractérisé en ce que la matière filmogène (a) est un polyuréthane obtenu par réaction d'un composé de formule

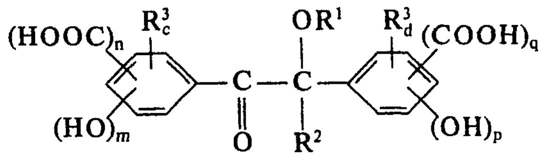

(II)

(dans laquelle $R^1$, $R^2$ et $R^3$ ont les significations données à la revendication 1, m et p sont chacun le nombre 1 et n et q sont tous les deux nuls) avec un diisocyanate aliphatique, cycloaliphatique, aromatique, araliphatique ou hétérocyclique-aliphatique, ou un prépolymère de celui-ci.

10. Procédé selon l'une quelconque des revendications précédentes, caractérisé en ce que le composé (b) est un composé pouvant être polymérisé en une matière macromoléculaire soluble dans un révélateur aqueux alcalin.

11. Procédé selon l'une quelconque des revendications 1 à 9, caractérisé en ce que le composé b est polymérisable en une matière macromoléculaire soluble dans un révèlateur aqueux acide.

12. Procédé selon la revendication 10, caractérisé en ce que le composé (b) comporte un groupe à insaturation éthylénique et un ou plusieurs groupes carboxyliques.

13. Procédé selon la revendication 12, caractérisé en ce que le groupe à insaturation éthylénique est un groupe acryloyloxy ou méthacryloyloxy.

14. Procédé selon la revendication 11, caractérisé en ce que le composé (b) comporte un groupe à insaturation éthylénique et un ou plusieurs groupes amino.

15. Procédé selon la revendication 14, caractérisé en ce que le composé (b) est un acrylate ou un méthacrylate d'alkylaminoalkyle, un acrylate ou un méthacrylate de dialkylaminoalkyle ou une vinylpyridine.

16. Procédé selon l'une quelconque des revendications précédentes, caractérisé en ce que la composition de réserve comprend au moins une mole du composé (b) par groupe de formule I de la matière a.